Europäisches Patentamt

(19) European Patent Office

Office européen des brevets

(11) Publication number: **0 184 943**

**B1**

(12) **EUROPEAN PATENT SPECIFICATION**

(45) Date of publication of patent specification: 26.09.90

(21) Application number: **85309104.9**

(22) Date of filing: **13.12.85**

(51) Int. Cl.⁵: **B 23 K 1/00, H 05 K 13/04**

(54) Soldering arrangement.

(30) Priority: **14.12.84 JP 262691/84**

(43) Date of publication of application:
**18.06.86 Bulletin 86/25**

(45) Publication of the grant of the patent:
**26.09.90 Bulletin 90/39**

(84) Designated Contracting States:
**FR GB IT**

(56) References cited:
**FR-A-1 366 277**
**US-A-3 486 004**
**US-A-3 674 975**

(73) Proprietor: **Hy-Bec Corporation**
**Yasuda Building 2-15-14 Tsukiji**
**Chuo-ku Tokyo (JP)**

(72) Inventor: **Hayakawa, Futomi**
**c/o Japan Lamp Limited Yasuda Building**
**2-15-14 Tsukiji Chuo-ku Tokyo (JP)**
Inventor: **Onoda, Kazuo**
**2-6-23 Wakamiya**
**Okegawa-shi Saitama-ken (JP)**

(74) Representative: **Ayers, Martyn Lewis Stanley**
**et al**
**J.A. KEMP & CO. 14 South Square Gray's Inn**
**London, WC1R 5EU (GB)**

## Description

### Background of the invention

#### 1. Field of the invention

The present invention relates to an apparatus for assembling especially miniature IC-packages on a printed circuit board and, in particular, to an arrangement for soldering the lead pins on the IC-package with the corresponding lead lines on the printed circuit board under the use of radiation rays, for attaining firm and reliable connection of them with a prompt operation.

#### 2. Description of the prior art

Miniature IC-packages have the advantage that they permit higher package density by mounting many IC-packages on a single printed circuit board, especially, as in memory elements. Such a type of IC-package includes, for instance, SOP (Small Outline Package) having lead pins guided out in two directions and FPP (Flat Plastic Package) having lead pins guided out in four directions.

As is assumed, these kinds of IC-packages would tend to have their lead pins arranged in more and more dense distribution in accordance with the growing general demand for multiplicate functionalities of LSI.

There have been known as the means for soldering the lead pins on an IC-package with the corresponding lead lines on a printed circuit board, for example, heating with soldering iron, heating by pulse heater, infrared ray heating with reflowing and heating by hot-air [See, for example, "Denshi-Zairyo" (Electronics Materials) No. 2, p. 37 (1985)] and, as proposed recently, use of laser beams ["Keikinzoku-Yosetsu" (Welding of Light Metals) Vol. 17, No. 1 (1979)]. The known techniques have, however, revealed many undesirable problems. Thus, a miniature IC-package has in general its lead pins disposed with a narrow pin pitch. Here, a positioning in alignment of the lead pins with the solder pad requires higher accuracy when the number of lead pins are large and, in addition, occurrence of electric short circuit to the neighbouring pins due to excessive application of solder may be enhanced, so that minute and close administration of the operations and sophisticated techniques for the printing application of solder paste and for the mounting of IC-packages on the printed circuit board, etc., are required. For the materials of the print circuit board, those exhibiting very low heat resistance, such as paper, phenol resin and so on, have recently come to find practical use for the sake of economy, so that printed circuit boards are apt to suffer from a thermal damage when employing, in particular, an infrared ray heating with reflowing, heating with hot-air or laser beam heating. When a laser beam is employed, a stable soldering may be permitted, since there occurs no debasement of the material in the heat entrance head with time by, for example, formation of oxide layer and so on, as contrasted to the technique by thermal conductivity, such as, the use of soldering iron and so on. The technique of using laser beam has, however, a disadvantage that a complicated device is necessary for positioning the optical exit member for the laser beam guided through a flexible fiber so as to focus the beam onto the site to be soldered. Here part of the laser output energy will be scattered onto portions other than the sites to be soldered due to diffraction of the beam and injures the material (IC-packages, printed circuit board and so on), resulting in a debasement of the final product of manufacture.

US—A—3674975 (Nugent et al) discloses a soldering apparatus in accordance with the precharacterizing portion of claim 1. The apparatus includes radiant heat lamps mounted on opposite sides of a soldering chamber and disposed to provide a single horizontal tubular heating zone enveloping the device to be soldered.

FR—A—1366277 (IBM Corp) discloses a soldering apparatus for use with modular circuits and in which lines of contacts on opposed sides of a modular circuit are heated using heating plates to solder the circuit module to a circuit board. It also discloses the use of a radiant heat lamp and a condensing element to direct radiant heat onto a line of contacts to be soldered.

The present invention provides a soldering apparatus for connecting lead pins on IC-packages mounted on a printed circuit board with corresponding lead lines on the printed circuit board with solder, comprising

a mounting base provided with one or more pairs of arms disposed on opposite sides of the mounting base;

one or more pairs of heat source lamp units for producing radiant rays and focussing them onto sites of contact of the lead pins with the lead lines to be soldered, each of said lamp units being adjustably connected to a respective one of said arms and disposed to be on respective sides of the IC-package, and

a support shaft having pressing means at its lower end for steadying the IC-package on the printed circuit board on a work table, characterized in that

said one or more pairs of arms are mounted extending from the base at an angle to the perpendicular, and

the heat source lamp units producing radiant heat rays are disposed to focus them onto at least one pair of spaced parallel lines along the said sites of contact of opposed lead pins, and in that said support shaft passes slidably through said mounting base.

The number of arms employed correspond thus to the number of heat source lamp units employed. When two heat source lamp units are employed, two bundles of radiant rays are directed simultaneously to the portions to be processed by soldering. These bundles of radiant rays are focussed each in a form of a segment of a line onto the respective rows of sites to be soldered existing on the opposing sides of the IC-package. When four heat source lamp units are used, four bundles of radiant rays are focussed simultaneously onto four rows of soldering sites disposed on the rectangularly crossing two pairs of opposing sides of the IC-package each in a form of a segment of a line corresponding to each row of the sites to be processed by soldering mentioned above. The distance between the opposing two linear focussed beam spots (focussed lines) for each pair of bundles can be adjusted by rotating the heat source lamp units around each axis for angular adjustment by releasing and tightening the corresponding bolt-nut unit disposed on said axis for angular adjustment. The width between the paired focussed lines corresponds to the distance between the two linear rows of the sites to be soldered existing on the opposing sides of the IC-package. The heat source for the lamp unit should preferably consist of a near infra-red ray lamp.

The invention will be further described by way of example with reference to the accompanying drawings, in which:—

Fig. 1 shows the essential part of a first embodiment of the arrangement according to the present invention in a vertical section;

Fig. 2 shows the connection part of a heat source lamp unit in a plan;

Fig. 3 illustrates one embodiment of the heat source lamp unit in a vertical section;

Fig. 4 is a plan of the lamp unit corresponding to Fig. 3;

Fig. 5 is a side view of a mirror body in the lamp unit;

Fig. 6 shows a cooling water circulation system for the mirror body of the lamp unit in a plan (A) and in a vertical section (B) along the line A—A in Fig. 4;

Fig. 7 illustrates an IC-package mounted on a printed circuit board in a plan (A) with its lead pins being indicated in a symbolized form and in a vertical section (B) with the printed circuit board and IC-package being indicated both in a symbolized form;

Fig. 8 is a plan of a second embodiment of the arrangement according to the present invention in the portion of the heat source lamp units;

Fig. 9 is a side view of the embodiment of Fig. 8 and

Fig. 10 is an explanatory illustration showing three IC-packages having different sizes, in which one has a pair of opposing rows of lead pins and the others have each two pairs of opposing rows disposed on the four sides of the package, found in processing on a printed circuit board.

Detailed description of preferred embodiments
1. Arrangement of a first embodiment

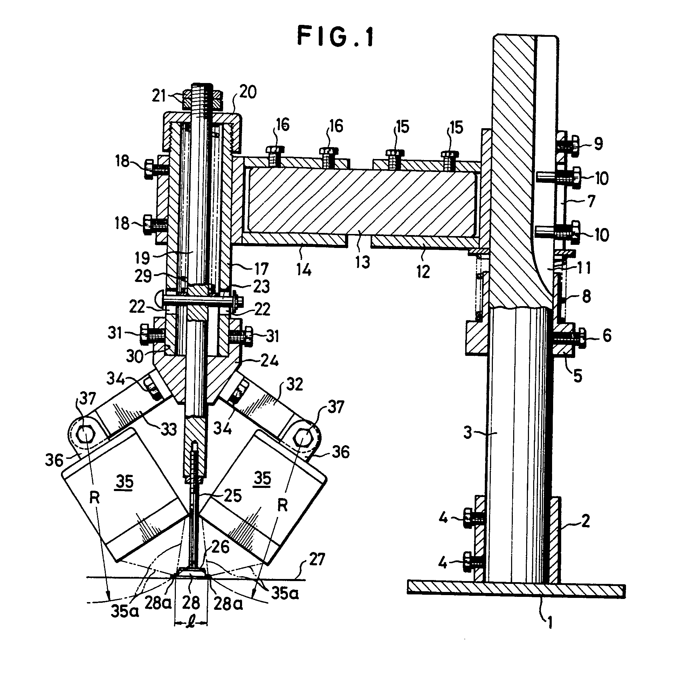

In Fig. 1, a general view of the essential part of a first embodiment of the soldering arrangement according to the present invention is shown in a partly sectioned elevation. The arrangement is fixedly mounted on a basement 1, which is connected fixedly to a not shown stationary member, such as, work table. The basement 1 carries a mounting cylinder 2 in which the lower end of a strut 3 is inserted and fixed by several tightening screws. On the strut 3 is fixed a support member 5 by slipping thereon and tightening by a screw 6 at an adequate level. A sleeve 7 is slipped on the strut 3 and fixed at a suitable position by tightening screw 9. Between the sleeve 7 and the support member 5, a spring 8 is disposed. Two key screws 10 are attached to the sleeve 7 so as to intrude its front end into a key way 11 provided in the strut 3 to prevent rotation of the sleeve 7. Sleeve 7 carries a bracket 12 having a receptacle cave into which one end of a connection rod 13 is inserted and fixed by tightening screws 15. The other end of the connection rod 13 is inserted into a receptacle cave of another bracket 14 arranged on a sleeve supported on a tubular support 17 and is locked with tightening screws 16. Both ends of the connection rod 13 are thus held firmly in the respective receptacle caves so as to permit a voluntary adjustment of the depth of insertion to settle a definite distance between the strut 3 and the tubular support 17. The sleeve of the bracket 14 is supported on the tubular support 17 by slipping thereon and fixing with tightening screws 18. The tubular support 17 serves for supporting the soldering arrangement according to the present invention.

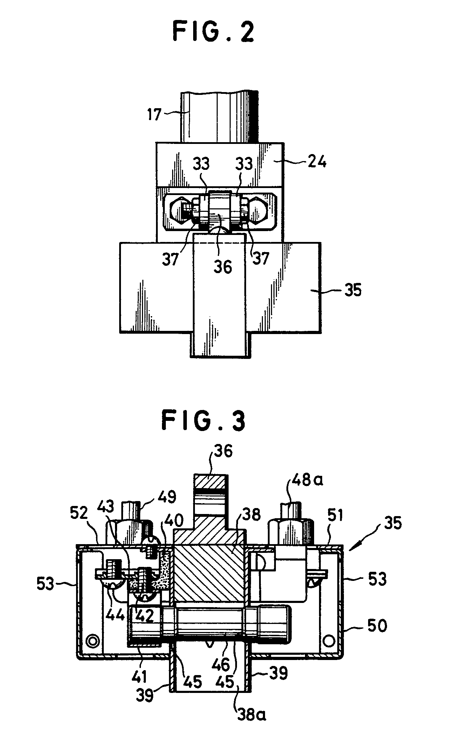

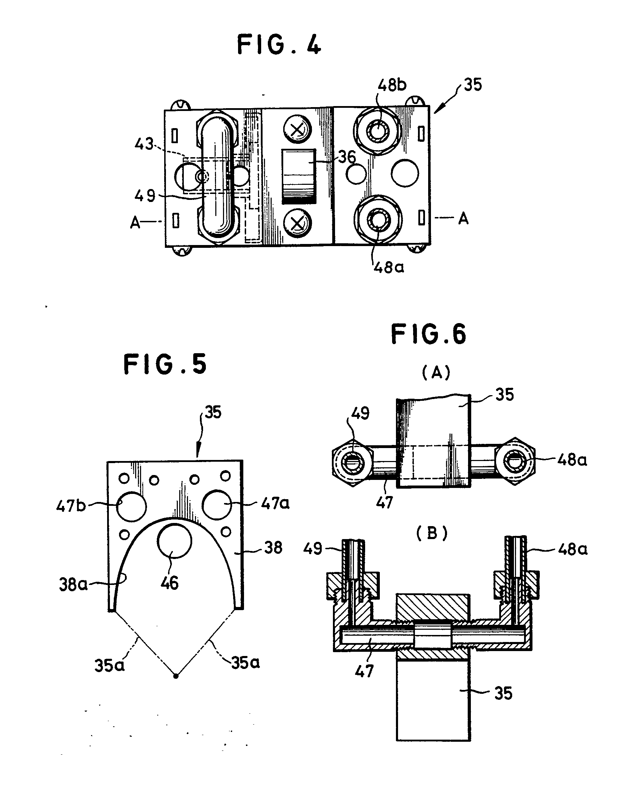

Inside the tubular support 17 is arranged a support shaft 19 extending therethrough and projecting at the upper end thereof out of a cap 20 closing the upper end of the tubular support 17. On the upper end of the support shaft 19 projecting above the cap 20, a double nut 21 is screwed so as to permit fine adjustment of the vertical position of the support shaft 19 by manipulating the double nut 21. At a lower portion of the tubular support 17, two long holes 22, 22 are disposed diametrically relative to the support shaft 19, in which a guide pin 23 is inserted with a play. The guide pin is allowed to move in vertical direction within the holes 22, 22. The adjustment of this vertical movement in the holes 22, 22 is effected by the manipulation of the double nut 21. The lower end of the support shaft 19 projects down through a mounting base 24 explained afterwards. On the so projecting lower end of the support shaft 19 is arranged a rod 25 which carries at its lower end a press plate 26 for arresting the IC-package on the printed circuit board by pressing on it. The upper part of the rod 25 is threaded so as to engage with the corresponding thread formed in the lower end of the support shaft 19 to connect therewith. The press plate 26 disposed at the lower end of the rod 25 arrests the IC-package 28 mounted on a printed circuit board 27 by pressing down the upper face thereof, in order to insure against any displacement between the IC-package 28 and the printed board 27. For alleviating the shock upon contact of the press plate 26 onto the IC-package 28, a spring 29 is interposed between the guide pin 23 and the cap 20 within the tubular support 17. While the press plate 26 is formed in this embodiment in a nearly rectangular configuration, it is possible that the press plate 26 has a greater size than the IC-package 28 and is provided with suitable pass ways, such as, slits and the like, to allow penetration of the heat rays to the soldering sites. The mounting base 24 has a cut-out 30 at its upper face, adapted to receive the lower end of the tubular support 17. The lower end of the tubular support 17 is inserted in the cut-out 30 and is fixed by tightening screws 31 to form an integral body therewith. On the mounting base 24, two arms 32 and 33 are arranged diametrically with respect to the support shaft 19 and are fixed by screws 34, 34. Each of the arms 32, 33 carries a heat source lamp unit 35, 35 at its front end so as to allow free adjustment of the angle of inclination of the lamp unit. Thus, the heat source lamp unit 35 has at the center of its base a connection member 36, as best shown in Figs. 3 and 4, and the two lamp units 35, 35 are supported on the arms 32, 33 each by an adequate fastening member, such as, bolt-nut unit, so as to permit a voluntary adjustment of the inclination angle of the lamp unit, whereby a desired adjustment of the location of focussed line of the heat rays onto the sites to be soldered on the printed circuit board can be attained. Thus, each of the focussed lines of the lamp units 35, 35 moves on a circular locus having a radius R around an axis of angular regulation 37 and is settled at a requisite position by the bolt-nut unit 37. When an IC-package 28 having provided with two rows of lead pins 28a on the opposite sides of the printed circuit board 27 is processed by soldering, the heat source lamp units 35, 35 are set by bolt-nut units 37, 37, so as to let coincide each focussed line with the row of the spots to be soldered on the printed circuit board on the both sides of the IC-package 28 by adjusting the angle of inclination of the lamp units 35, 35 around the axes 37, 37 respectively, in such a manner that a proper distance (I) for the soldering rows is left between the two focussed lines. Thus, it is possible to vary the angle of inclination of each of the lamp units voluntarily so as to adjust the location and distance of the focussed lines to meet every specific condition even if the size of the IC-package 28, and thus, the distance "I" is altered in a practical processing of a multi-package unit.

Explaining now the heat source lamp unit 35 with reference to Figs. 3 to 6, it includes a mirror body 38 having a mirror face 38a. Both sides of the mirror body 38 are covered each by a reflector plate 39. The mirror face 38a and the internal surfaces of the reflector plates 39, 39 are plated with, for example, gold, to increase the reflectivity. A ceramic base 40 having a sectional form of L is incorporated, on which a socket 41 for the heat source lamp is fixed by a small screw 42. The small screw 42 connects also a terminal plate 43 for the lamp with the power source via another small screw 44 and a lead wire (not shown). The reflector plates 39, 39 have each a perforation 45, through which the lamp 46, which is a near infrared ray lamp having a linear form, is inserted, so as to rest itself in the socket 41 by its one end. The mirror body 38 is provided with a pair of cooling water canals 47a, 47b in parallel at a distance. The cooling water is supplied from one end of the canal 47a and flows therethrough leaving the other end into a connection path 49 and entering into the other canal 47b at its one end and is exhausted from the other end 48b. The entire mirror body 38 is accommodated in a housing 50 which is covered in its upper face by a cover plate 51. A hole 52 serves to guide the electric current cable connected to the lamp. The housing 50 is provided with slits 53 serving for air ventilation.

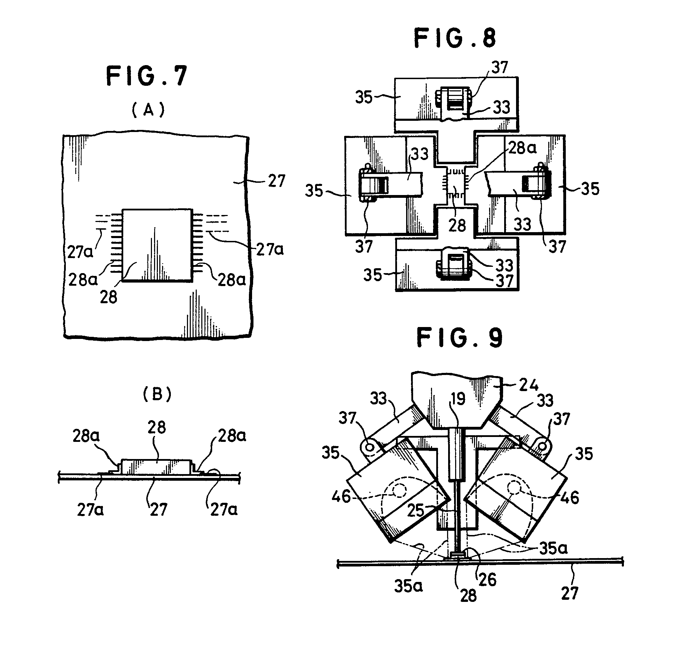

Now, the explanation is directed to a soldering operation in which an IC-package 28 having provided with a pair of rows of lead pins 28a on two opposite sides of the package is processed by soldering each lead pin with the corresponding lead line 27a on the printed circuit board 27, as shown in Fig. 7.

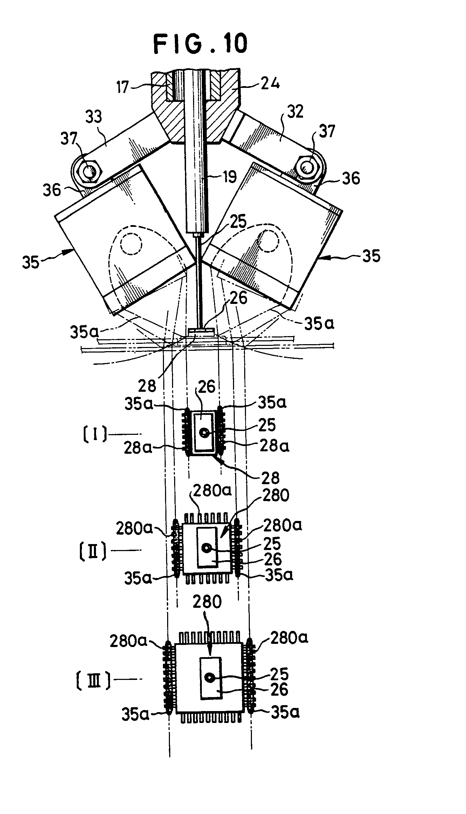

The printed circuit board 27 is placed on the work table underneath the support shaft 19. The IC-package 28 is mounted on the printed circuit board 27 at a predetermined position and the relative position of the two is adjusted so as to align each lead pin 28a with the corresponding lead line 27a. After the positioning of the two has been achieved as above, the heat source lamp units 35, 35 are set so as to coincide each of the focussed lines with the rows of the sites to be soldered, namely, the positions at which the lead lines 27a, 27a are overlaid by the lead pins 28a, 28a, by adjusting the bolt-nut units 37, 37. The support shaft 19 is lowered to let the press plate 26 come to abut on the IC-package 28. In this condition, the heat source lamps 46 are energized, which produce each a bundle of heat rays 35a, which is focussed onto the soldering site and produces a temperature of, for example, 200—900°C. The heat rays are reflected by the mirror face 38a and are focussed onto the soldering site in a form of a segment of a line covering the row of connection points of the lead pins 28a on the IC-package with the lead lines 27a on the printed circuit board (as best illustrated in Fig. 10). The soldering can be effected within a very short period of time (5—8 seconds) in both the rows of the connection points on both sides of the IC-package 28 simultaneously.

For an IC-package 280 provided with four rows of lead pins 280a on the two pairs of opposing sides thereof, the same procedures as explained above are first performed and, then, the support shaft 19 is raised against the tension force of the spring 29 and the printed circuit board is rotated at right angle and the same procedures are repeated, so as to effect the soldering on the other two sides [the state shown in Fig. 10 (II)]. The size of the IC-package of Fig. 10 (III) is somewhat greater than that of Fig. 10 (II). For processing the packages of (II) and (III) of Fig. 10, the angle of inclination of the heat source lamp units has to be re-adjusted by the bolt-nut units 37, 37 before the operation, since the distance "I" between the rows of soldering sites in larger than that of the IC-package of (I) of Fig. 10.

On operating the soldering work, the mirror body 38 is cooled by flowing cooling water through the canals 47a, 47b, as explained previously, and also by the ventilating air through the ventilation slits 53.

## 2. Arrangement of a second embodiment

Figs. 8 and 9 illustrate a second embodiment of the soldering arrangement according to the present invention, in which two pairs of heat source lamp units are arranged diagonally and crossing rectangularly with each other. By this arrangement, four rows of the soldering sites on both pairs of opposing sides of the IC-package 280 can be soldered at a time.

Four heat source lamps 35 are disposed around the mounting base 24 in two pairs crossing rectangularly with each other. Each of the lamp units is connected to a arm 33 in the same manner as in the arrangement of the first embodiment, and thus, can be adjusted in its inclination angle by a bolt-nut unit 37. Thus, in this arrangement, another pair of lamp units having the same construction as given in the first embodiment is disposed additionally in rectangular direction to the first pair of lamp units of the first embodiment with the same connection means. Here, however, the second pair of lamp units is not disposed on the same vertical leval as the first one but the two pairs are arranged in two different levels, whereby the adjustment of the inclination angle of each lamp unit can be accomplished without disturbance by any of the other lamp units. All the other parts have the same structures as in the first embodiment and, hence, description of their details is omitted.

## Claims

1. A soldering apparatus for connecting lead pins (28a) on IC-packages (28) mounted on a printed circuit board (27) with corresponding lead lines (27a) on the printed circuit board (27) with solder, comprising

a mounting base (24) provided with one or more pairs of arms (32, 33) disposed on opposite sides of the mounting base (24);

one or more pairs of heat source lamp units (35) for producing radiant rays and focussing them onto sites of contact of the lead pins (28a) with the lead lines (27a) to be soldered, each of said lamp units (35) being adjustably connected to a respective one of said arms (33) and disposed to be on respective sides of the IC-package, and

a support shaft (19) having pressing means at its lower end for steadying the IC-package (28) on the printed circuit board (27) on a work table, characterized in that

said one or more pairs of arms (33) are mounted extending from the base (24) at an angle to the perpendicular, and

the heat source lamp units (35) producing radiant heat rays are disposed to focus them onto at least one pair of spaced parallel lines along the said sites of contact of opposed lead pins (28a), and in that said support shaft (19) passes slidably through said mounting base (24).

2. A soldering apparatus according to claim 1 wherein the heat source lamp units (35) are pivotably connected to respective ones of said arms (33) so as to permit adjustment of the angle of inclination of each lamp unit (35) around an axis of adjustment.

3. A soldering apparatus according to claim 1 or 2 wherein the support shaft (19) is adjustable in its vertical position relative to the work table.

4. A soldering apparatus according to any one of claims 1 to 3, wherein the heat source of said lamp unit (35) consists of a near-infrared ray lamp (46) of linear form.

5. A soldering apparatus according to any one of claims 1 to 4, wherein two pairs of arms (32, 33) are fixed on the mounting base (24) in a rectangularly crossing relation to each other and each having a heat source lamp unit mounted thereon, and wherein each pair of arms (33) is disposed at a different level to the other pair.

6. A soldering apparatus according to any one of claims 1 to 5, wherein the support shaft (19) is arranged so as to extend within a tubular support (17) and is resiliently supported therein by a spring (29) disposed inside the tubular support.

7. A soldering apparatus according to claim 6 wherein a double nut (21) is screwed on the support shaft (19) at its upper end projecting above the tubular support (17), so as to allow an adjustment of the tension of said spring (29) by manipulating said double nut (21).

8. A soldering apparatus according to any one of claims 1 to 7, wherein the heat source lamp unit (35) is connected to the front end of each of said arms (32, 33) fixed on the mounting base (24), by means of a bolt-nut unit (37) serving as said axis for angular adjustment.

## Patentansprüche

1. Lötvorrichtung zum Verbinden von Anschlußstiften (28a) von an einer gedruckten Schaltung (27) angeordneten integrierten Schaltungen (28) mit entsprechenden Anschlußleitungen (27a) auf der gedruckten Schaltung (27a) mittels Lötmittel, mit

—einer Montagebasis (24), die mit einem Paar oder mit mehreren Paaren von Armen (32, 33) versehen ist, die an entgegengesetzten Seiten der Montagebasis (24) angeordnet sind,

—einem Paar oder mehreren Paaren von Wärmequelle-Lampeneinheiten (35) zur Erzeugung von Strahlen und zum Fokussieren derselben auf zu verlötende Kontaktierungsstellen der Anschlußstifte (28a) mit den Anschlußleitungen (27a), wobei jede Lampeneinheit (35) einstellbar an einem jeweiligen Arm (33) angeschlossen und zu einer Seite der integrierten Schaltung zugehörig angeordnet ist, und

—einem Halteschaft (19) mit einer Druckeinrichtung an seinem unteren Ende zum Stabilisieren der integrierten Schaltung (28) auf der gedruckten Schaltung (27) auf einem Arbeitstisch, dadurch gekennzeichnet, daß eine Paar oder die Paare von Armen (33) von der Basis unter einen Winkel gegen die Lotrechte wegstehen und die Wärmestrahlen erzeugenden Wärmequelle-Lampeneinheiten (35) angeordnet sind zum Fokussieren der Wärmestrahlen auf mindestens ein Paar von beabstandeten parallelen Linien entlang den Kontaktierungsstellen von entgegengesetzten Anschlußstiften (28a), und daß der Halteschaft (19) sich gleitbeweglich durch die Montagebasis (24) hindurch erstreckt.

2. Lötvorrichtung nach Anspruch 1, dadurch gekennzeichnet, daß die Wärmequellen-Lampeneinheiten (35) zur Einstellung des Neigungswinkels jeder Lampeneinheit (35) um eine Einstellachse herum an jeweils einem der Arme (33) schwenkbeweglich angeschlossen sind.

3. Lötvorrichtung nach Anspruch 1 oder 2, dadurch gekennzeichnet, daß der Halteschaft (19) in seiner vertikalen Position relativ zum Arbeitstisch einstellbar ist.

4. Lötvorrichtung nach einem der Ansprüche 1 bis 3, dadurch gekennzeichnet, daß die Wärmequelle der Lampeneinheit (35) aud einer linear ausgebildeten, nahe dem Infrarot-Strahlenbereich strahlenden Lampe besteht.

5. Lötvorrichtung nach einem der Ansprüche 1 bis 4, dadurch gekennzeichnet, daß zwei Paare von Armen (32, 33) an der Montegebasis (24) sich rechtwinkelig überkreuzend befestigt sind, wobei an jedem eine Wärmequelle-Lampeneinheit angeordnet ist, und daß jedes Paar von Armen (33) in Bezug auf das andere Paar auf einer unterschiedlichen Höhe angeordnet ist.

6. Lötvorrichtung nach einem der Ansprüche 1 bis 5, dadurch gekennzeichnet, daß der Halteschaft (19) derart angeordnet ist, daß er sich durch eine rohrförmige Halterung (17) erstreckt und darin mittels einer Feder (29) federnd angestützt ist, die im Inneren der rohrförmigen Halterung angeordnet ist.

7. Lötvorrichtung nach Anspruch 6, dadurch gekennzeichnet, daß auf den Halteschaft (19) an dessen oberem über die rohrförmige Halterung (17) überstehendem Ende eine Kontermutter (21) aufgeschraubt ist, wobei eine Einstellung der Spannung der Feder (29) durch Bedienung der Kontermutter möglich ist.

8. Lötvorrichtung nach einem Ansprüche 1 bis 7, dadurch gekennzeichnet, daß die Wärmequelle-Lampeneinheit (35) and das Vorderende jedes an der Montagebasis (24) befestigten Arms (32, 33) mittels einer Schraubbolzen-Mutter-Einheit (37) angeschlossen ist, die als Achse zur Winkeleinstellung vorgesehen ist.

## Revendications

1. Appareil de brasage pour raccorder les broches de connexion (28a) de boîtiers de circuit intégré (28) montés sur une carte imprimée (27) avec les lignes d'amenée correspondantes (27a) de la carte imprimée (27) avec un métal de brasage, comprenant

uns base de montage (24) équipée d'une ou de plusieurs paires de bras (32, 33) disposés et de part et d'autre de la base de montage (24);

une ou plusieurs paires d'unités de lampe chauffantes (35) pour produire des rayons et les focaliser sur les sites de contact des broches de connexion (28a) avec les lignes amenée (27a) à braser, chaque unité de lampe (35) étant montée de façon réglable sur un bras (33) respectif et étant disposée sur des côtés respectifs du boîtier de circuit intégré, et

un arbre support (19) ayant des moyens de pression au niveau de son extrémité inférieure pour stabiliser le boîtier de circuit intégré (28) sur la carte imprimée (27) sur une table de travail, caractérisé en ce que

cette(ces) paire(s) de bras (33) est(sont) montée(s) en partant de la bras (24) en faisant un angle sur la perpendiculaire à cette base, et

les unités de lampe chauffantes (35) produisant les rayons de chaleur rayonnante sont disposées pour les focaliser sur au moins deux lignes parallèles espacées longeant les sites de contact des broches de connexion opposées (28a), et

l'arbre support (19) passe en coulissant à travers la base de montage (24).

2. Appareil de brasage selon la revendication 1, dans lequel les unités de lampe chauffantes (35) sont montées, pivotantes, sur les bras correspondants (33) de façon à permettre de régler l'angle d'inclinaison de chaque unité de lampe (35) autour d'un axe de réglage.

3. Appareil de brasage selon la revendication 1 ou la revendication 2, dans lequel l'arbre support (19) est réglable en position verticale par rapport à la table de travail.

4. Appareil de brasage selon l'une quelconque des revendications 1 à 3, dans lequel la source de chaleur de chaque unité de lampe (35) est une lampe (46) rayonnant dans le proche infrarouge et ayant une forme rectiligne.

5. Appareil de brasage selon l'une quelconque des revendications 1 à 4, dans lequel deux paires de bras (32, 33) sont fixées sur la base de montage (24) en étant perpendiculaires l'une à l'autre, une unité de lampe chauffante étant montée sur chaque bras, et dans lequel chaque paire de bras (33) est disposée à un niveau différent de l'autre paire.

6. Appareil de brasage selon l'une quelconque des revendications 1 à 5, dans lequel l'arbre support (19) est agencé pour s'étendre à l'intérieur d'un support tubulaire (17) et est élastiquement supporté dans ce support par un ressort (29) disposé à l'intérieur du support tubulaire.

7. Appareil de brasage selon la revendication 6, dans lequel un double écrou (21) est vissé sur l'arbre support (19) au niveau de son extrémité supérieure se projetant au-dessus du support tubulaire (17) de façon à permettre de régler la tension du ressort (29) par le vissage ou le dévissage de ce double écrou (21).

8. Appareil de brasage selon l'une quelconque des revendications 1 à 7, dans lequel l'unité de lampe chauffante (35) est montée sur l'extrémité avant de chaque bras (32, 33) fixé sur la base de montage (24), au moyens d'une unité boulon/écrou (37) servant d'axe pour le réglage angulaire.

EP 0 184 943 B1

FIG.1

FIG . 2

FIG . 3

# FIG.4

# FIG.5

# FIG.6

(A)

(B)

# FIG.7

### (A)

### (B)

# FIG.8

# FIG.9

4

# FIG. 10